# EUROPEAN PATENT APPLICATION

(11) **EP 2 336 796 A1**
(43) Date of publication of application: **22.06.2011**
(21) Application number: 09178540.2
(22) Date of filing: 09.12.2009
(51) Int. Cl.: G01R 31/36, H02J 7/00

(54) **Battery monitoring system**

(71) Applicant: STL Technology Co., Ltd., Kaohsiung City 80681 (TW)
(72) Inventor: Yang, Jui-Sheng, Kaohsiung City 80681 (TW); Chen, Hsien-Hung, Kaohsiung City 80681 (TW)
(74) Representative: Chaillot, Geneviève

(57) **Abstract**

A battery monitoring system (1) includes a detector (11) and a supervisor (12) connected to the detector (11). Wherein, pluralities of sensors (113) of the detector (11) respectively disposed on battery cells (21) of the battery (2) for at least correspondingly detecting voltage and temperature signals of the battery cells (21). Subsequently, the aforementioned signals are transmitted to a central processor (112) for a separate conversion into accessible and distinguishable data applied to compare with a predetermined threshold. Finally, the compared results would be shown on the supervisor (12) for users to realize the physical state of each battery (2). The central processor (112) reacts to the compared result under the irregular state and emits a warning signal to the supervisor (12), for which to promptly carry out a warning action.

## Description

### BACKGROUND OF THE INVENTION

### 1. Field of the Invention

The present invention relates to a monitoring system, in particularly to a battery monitoring system adapted to monitor a healthy status of the battery.

### 2. Description of the Related Art

Technical development has been changed rapidly with each passing day; people utilize electricity to drive more and more transportation or vehicles in order to effectively reduce air pollution. Accordingly, the battery likely becomes the main power source for the future transportation. Practically, since the transportation would be impossibly driven by a single battery, pluralities of batteries that are parallelly or serially connected to form a battery pack provided on the transportation to guarantee the sufficient energy. As such, in order to ensure the using rate of the battery, it is noted that a careful and strict examination of the battery such as the charging condition, maintenance, and safety is requisite. However, due to the fact that the batteries are serially and parallelly connected, the existing examination technology could merely detect the integral status of the entire battery pack but not of battery units within the battery pack. Therefore, if the battery pack is damaged, technicians have to detach the battery units from the battery pack and test the battery units respectively for finding out the breakdown one. Obviously, such detection wastes time and becomes inconvenient.

Accordingly, various existing measures for testing battery are developed as follows:
"Battery monitoring system" issued by a US Patent 4, 217, 645 adopts parameters for automatically and respectively monitoring multiple batteries. In a remote scanner means, a plurality of sensors provides with analog signals corresponding with those parameters to execute the monitoring action. While any parameter of the battery cell is above a threshold, an alarm is triggered. Wherein, the remote scanner means could be merely applied to monitor and display the voltage status of the battery, and such monitoring action merely acts on the surface of the battery. Thus, if a battery pack is formed by batteries under a parallel and serial connection, such typical system would make nonsense of the determination for a single breakdown battery therein, thence incurring a great difficulty in maintenance and repair. Moreover, in the practical application, on the sole basis of the voltage detection would not substantially lead to a precise and complete determination of the single battery.
"Battery monitor for electric vehicles" issued by a US Patent 5,808,469 shows a battery monitor for monitoring and judging the voltage and temperature of batteries associated with a battery pack of an electric vehicle. Whereby, a controller means selectively activates one of the switches to select a particular battery voltage signal and deactivates the selected switch after a capacitor is charged by the selected battery voltage signal, so as to finally determine the battery voltage of the selected battery. However, such monitoring merely exams the integral battery; the detailed condition of the respective battery cells contained in each battery are still not monitored.
"On-line battery management and monitoring system and method" issued by a US Patent 6, 031, 354 shows the system utilizing a central monitoring station and a controller to perform the corresponding measure data and the related warning condition data, so that an initial maintenance command would be dispatched to solve an existing problem of the battery. However, this disclosure essentially computes the related operating parameters of the battery for determining whether to dispatch the initial maintenance command substantially but still fails to precisely detect the respective battery cells inside the battery. It should note that this disclosure merely employs an external examination on the integral battery, so the healthy condition of the individual battery cells is still unattainable.
"Battery voltage display apparatus for wireless communication system" issued by a US Patent 6,295,002 utilizes the cooperation of a wireless bidirectional communication, a power detecting system, and a displayer to perform the remaining power of the battery. Wherein, the detection of the power of the battery would be transmitted to a main system section within a predetermined time. Accordingly, if the detecting result is not timely received and presented, an error would be emitted for showing the status of the consumption of the power. Obviously, such means could merely detect and show the remained power of the integral battery; the detailed using status of each battery cell within the battery is still inaccessible.
"Vehicle tracker including battery monitoring feature and related methods" issued by a US Patent 6,819,269 substantially comprises a wireless communication device and a detector circuit. Wherein, when a sensed battery voltage is below a threshold, the operation of the receiver of the wireless communication device would be disabled. Accordingly, the using status of the battery cell contained in the battery is still unable to be detected.
"Battery monitor with wireless remote communication" issued by a US Patent 7,394,394 utilizes a ac signal applied to a battery for diagnosing if the battery is healthy. Similarly, such monitoring merely checks the integral using status of the battery but not the battery cells therein; therefore the healthy status of each battery cell is also unable to be monitored.

Consequently, the abovementioned prior arts merely disclose to have a monitoring device externally proceed detections upon the voltage or current conditions of the integral battery or battery pack; however, they are commonly ineffective to inspect the detailed healthy status of the respective battery cells in side each battery. In addition, a single signal does not provide thorough information to show the entire healthy status of the battery. Moreover, since the batteries are usually serially and parallelly connected, the replacement or repair is accordingly difficult due to the fact that the batteries contained therein should be tested and displaced one by one. Therefore, the monitoring could not be executed promptly and correctly, which results in failing to swiftly indicating the abnormal problems generated from the damaged batteries. As a result, the aforesaid disadvantages need remedy.

### SUMMARY OF THE INVENTION

The object of the present invention is to provide a battery monitoring system for speedily and correctly inspecting the healthy status of the battery cells within the battery, so that the subsequent replacement would be convenient.

The battery monitoring system in accordance with the present invention essentially includes a detector and a supervisor connected to the detector. Wherein, pluralities of sensors of the detector respectively disposed on battery cells of the battery, voltage and temperature signals of the battery cells are correspondingly detected. Afore signals would be integrated by an integrator of the detector for a central processor to convert those signals into accessible and distinguishable data, which could be further compared. The data and the compared results would thence be shown on the supervisor for users to realize the healthy status of each battery cell, so the succeeding substitution of the battery would be more fast and handy, which favorably increases the using convenience.

The advantages of the present invention over the known prior arts will become more apparent to those of ordinary skilled in the art by reading the following descriptions with the relating drawings.

### BRIEF DESCRIPTION OF THE DRAWINGS

- Fig. **1**: is a schematic view showing a first preferred embodiment of the present invention;
- Fig. **2**: is a schematic view showing the first preferred embodiment in inspection;
- Fig. **3**: is flowchart showing the detecting model of the first preferred embodiment of the present invention;
- Fig. **4**: is a schematic view showing a second preferred embodiment of the present invention;
- Fig. **5**: is a schematic view showing a third preferred embodiment of the present invention;
- Fig. **6**: is flowchart showing the detecting model of the third preferred embodiment of the present invention;
- Fig. **7**: is a schematic view showing a fourth preferred embodiment of the present invention; and

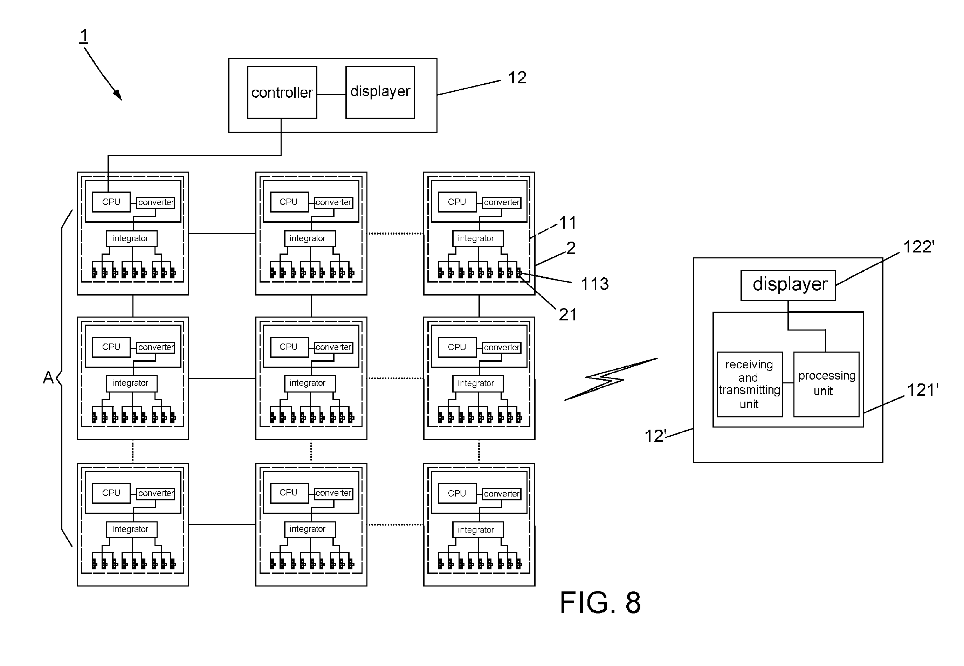

- Fig. **8**: is a schematic view showing a fifth preferred embodiment of the present invention.

### DETAILED DESCRIPTION OF THE PREFERRED EMBODIMENTS

Before describing in greater detail, it should note that the like elements are denoted by the similar reference numerals throughout the disclosure.

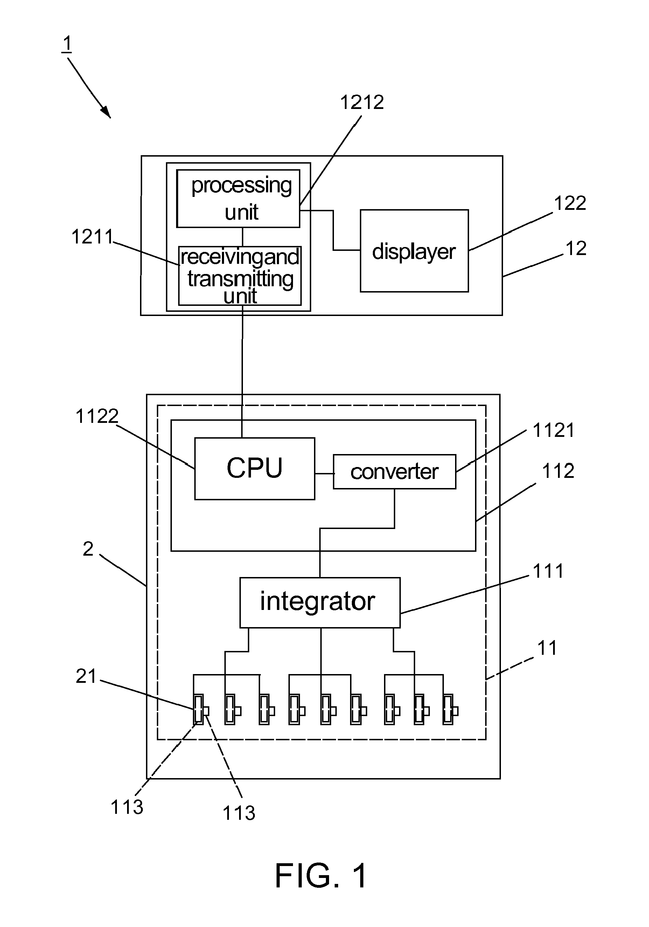

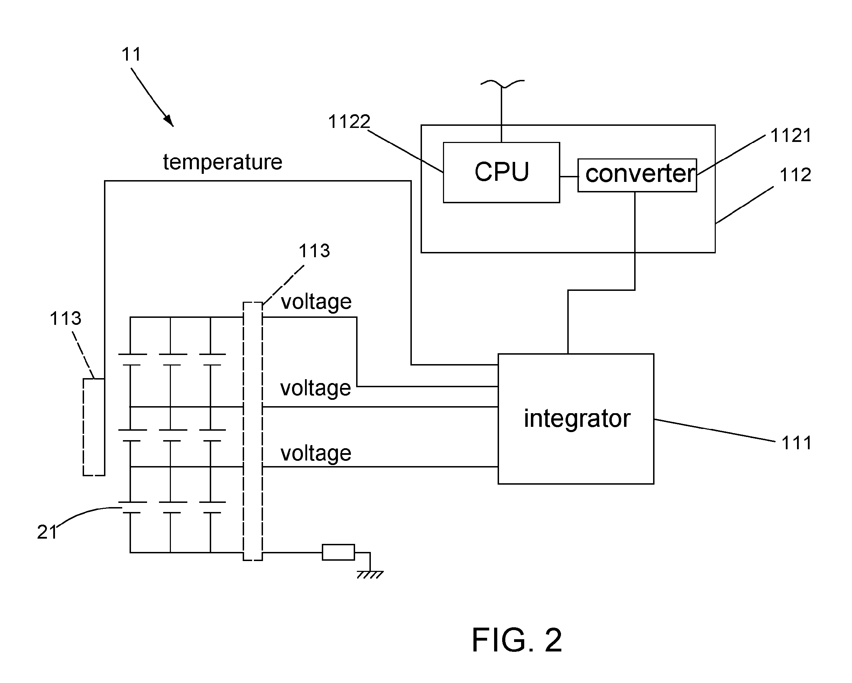

Referring to Figs. **1** and **2****,** a first preferred embodiment of the present invention shows a battery monitoring system **1** for inspecting the healthy status of a plurality of battery cells **21** in a battery **2** during using. The battery monitoring system **1** comprises a detector **11** and a supervisor **12** connected to the detector **11**. Wherein, the detector **11** includes an integrator **111**, and a central processor **112** as well as plural sensors **113** respectively connected to the integrator **111**. Herein, the sensors **113** are correspondingly disposed on each of the battery cells **21** for respectively sensing the temperature and voltage generated by the battery cell **21**. In this embodiment, the sensor **113** for sensing the temperature of the battery cell **21** could either contact or non-contact the battery cell **21** while the sensor **113** for sensing the voltage of the battery cell **21** could connect to the battery cell **21**. The sensors **113** connect to the integrator **111;** whereby the integrator **111** could integrate the received voltage signal and the temperature signal from the battery cell **21** and thence transmit those signals to the central processor **112.**

Continuing with the aforementioned, the central processor **112** has a converter **1121** and a central process unit (CPU) **1122** connected to the converter **1121**. Wherein, the converter **1121** serves to receive the voltage signal and the temperature signal of the battery cell **21** integrated by the integrator **111** and respectively convert them into separate voltage data and temperature data. In addition, the CPU **1122** previously saves a predetermined value therein and renders a decision making via comparing the voltage data and the temperature data with the predetermined value, so that a compared result is achieved.

The supervisor **12** includes a controller **121** for receiving the compared result from the CPU **1122** and a displayer **122** connected to the controller **121**. Wherein, the controller **121** receives the compared result from the CPU **1122** via a receiving and transmitting unit **1211**. Herein, the receiving and transmitting unit **1211** is either wirelessly or wiredly interconnected with the CPU **1122**. In this embodiment, the CPU **1122** wiredly interconnected with the receiving and transmitting unit **1211** is adopted as an example. Additionally, the receiving and transmitting unit **1211** connects to a processing unit **1212** that is further linked to the displayer **122.** Whereby, as the CPU **1122** concludes the compared result from the comparison and performs any abnormal state, a warning signal would be thence emitted to the supervisor **12** and be displayed on the displayer **122** via the controller **121.** As it should be, the warning signal could extensively adopt a twinkling alarm light, a buzzer, etc. to provide users with a caution. For a clear showing of the inner healthy status of the battery **2**, the displayer **122** adopts a screen as an example in this embodiment.

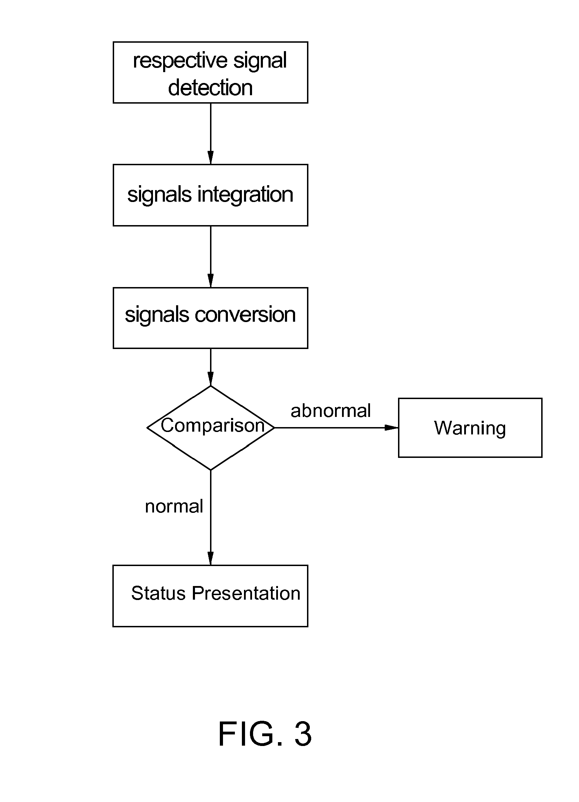

Referring to Figs. **1** to **3**, the battery monitoring system 1 could adapt to transportation, and the supervisor **12** and the detector **11** are connected wiredly. Namely, the screen (not shown) of the transportation is directed to the displayer **122** that is wiredly connected to the battery **2** via a controlling circuit (not shown), so that the controlling circuit is an equivalence of the controller **121**. In using, the transportation is driven by the battery **2** providing with electricity. Concurrently, the sensors **113** activates to freely sense the healthy status of each battery cell **21** in the battery **2** for capturing respective temperature and voltage signals and sends the signals to the integrator **111.** Hence, after the integrator **111** integrates the sensed temperature and voltage signals, the signals would be further transmitted to the converter **1121** of the central processor **112**. Whereby, the signals would be respectively converted into correspondent data for the CPU **1122** to compare them with the predetermined value so as to act a consistent analysis and judge a compared result. In this manner, the compared result would be transmitted to the controller **121**. Accordingly, the receiving and transmitting unit **1211** would thence receive the compared result and dispatch the same to the processing unit **1212** for activating the displayer **122** to present the using status of each battery cell **21.** Accordingly, if the compared result is abnormal, the CPU **1122** would timely emit a warning signal for the processing unit **1212** to trigger the displayer **122** carrying out a twinkling light or a buzz. Therefore, users could appreciate the healthy status of the battery cell **21** in using and directly change the anomalous battery **2**, which increases the using convenience.

What is more, while recycling the replaced battery **2**, the recycler could merely substitute the designated battery cells **21** that are damaged as only part of the battery cells **21** collapsed in the battery **2** incur the occurrence of insufficient current and voltage of the battery **2**. In general, a typical way to solve the above occurrence is to directly discard the entire battery **2,** which is however concerned to be wasteful. With the specific configuration invented by the present invention, the substitution of the battery cells **21** bring the battery **2** a long-lasting using life and preferably a repeated utilization, hence tallying with today's environmental protection concept.

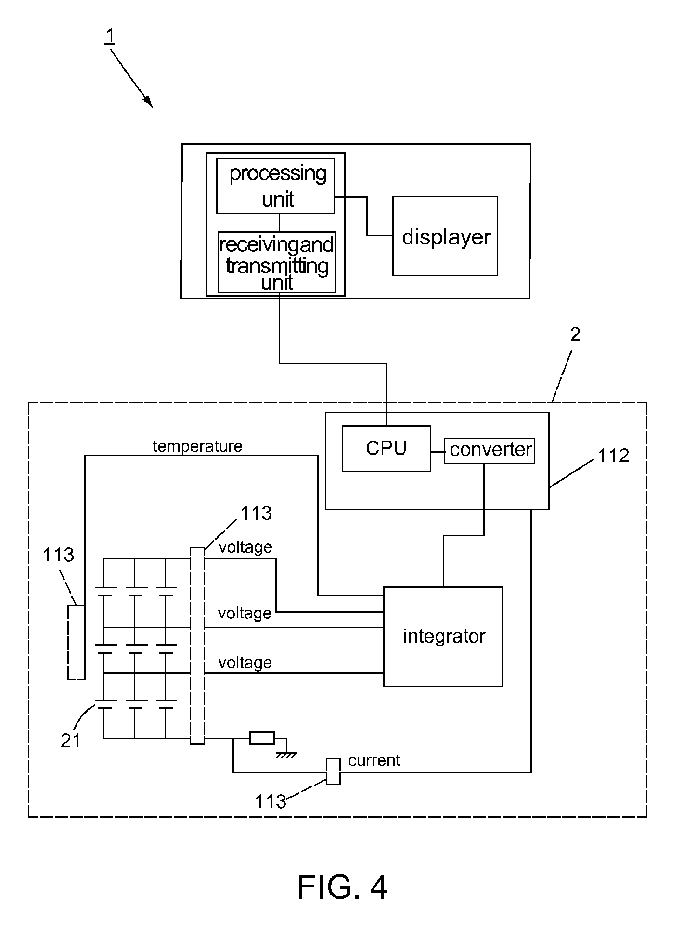

Referring to Fig. **4****,** a second preferred embodiment of the present invention contains the consistent elements with the first preferred embodiment. Wherein, a sensor **113** is additionally installed in correspondence with each battery cell **21** for sensing a current signal generated from the battery cell **21**. Whereby, besides sensing and integrating the voltage signal and the temperature signal, the sensed current signal could be directly transmitted to the central processor **112** via the sensor **113**. So that afore signals could be executed by conversion, differentiation, and analysis. Thus, in this embodiment, the sensors **113** provides comprehensive clues to judging the healthy status of the battery cell **21**, and the criterion to judge the damage condition of the battery **2** becomes precise.

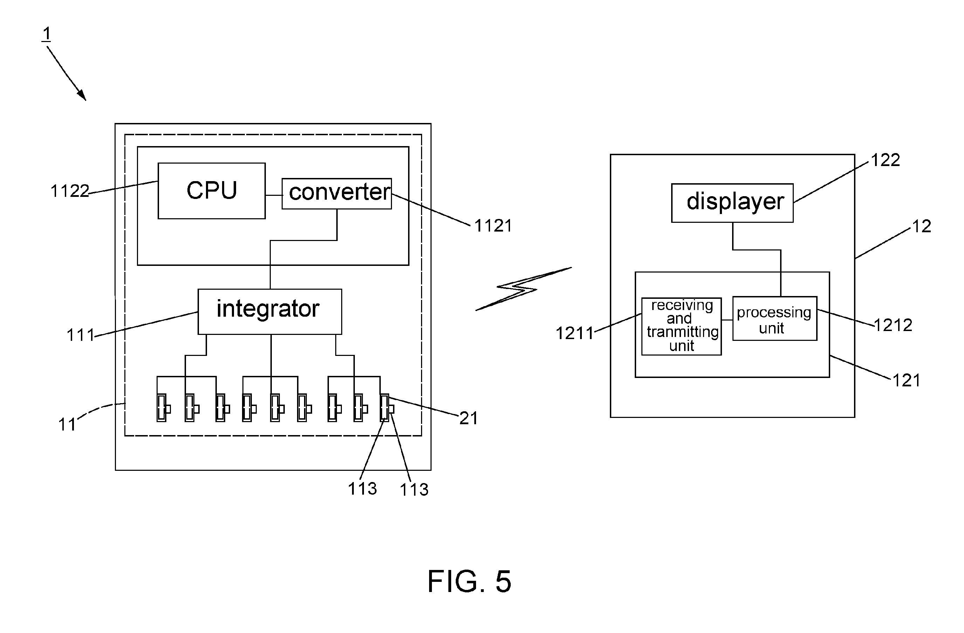

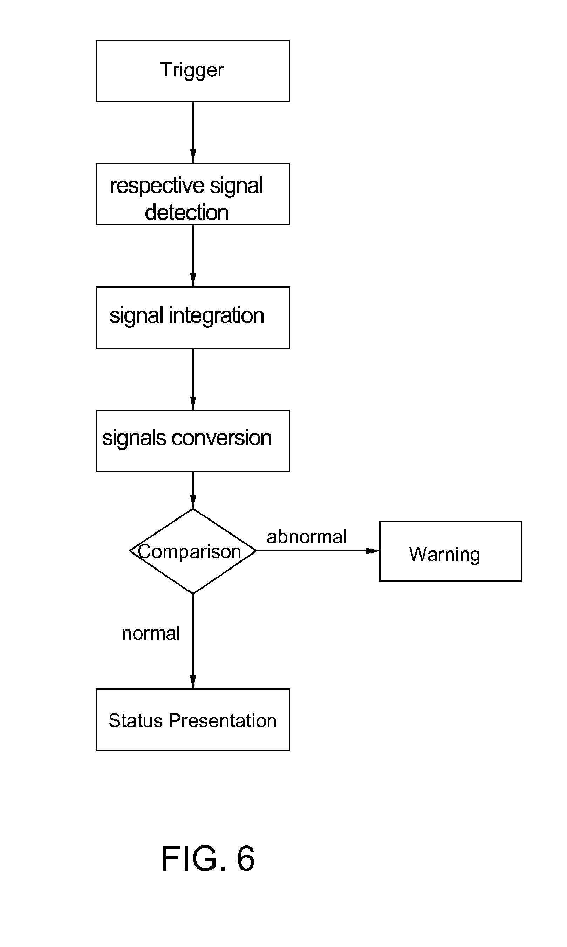

Referring to Figs. **5** and **6**, a third preferred embodiment of the present invention includes the same elements as those of the first preferred embodiment. Differently, the supervisor **12** and the detector **11** in this embodiment are connected wirelessly; namely, the supervisor **12** adopts manual. Wherein, the supervisor **12** still has a controller **121** connected to the CPU **1122** and a displayer **122** connected to the controller **121**. In using, the integrator **111** integrates the sensed temperature and voltage signals from the sensors **113** and then transmits the same to the converter **1121**, for which to convert those signals into consistent data. Thereby, the CPU **1122** would differentiate, compare, and analyze those data for deciding a compared result. Consequently, the compared result would be wirelessly transmitted to the receiving and transmitting unit **1211** of the controller **121,** so that the displayer **122** would show the consistent information thereon via the processing unit **1212**. If the compared result is abnormal, the CPU **1122** would immediately emit a warning signal for the processing unit **1212** to trigger the displayer **122** with the twinkling light or buzz, so that users would understand the healthy condition of each battery cell **21** through the controller **121**. In addition, the replacement of the damaged could be efficient, thus increasing the convenience in maintenance or in the application of external monitoring.

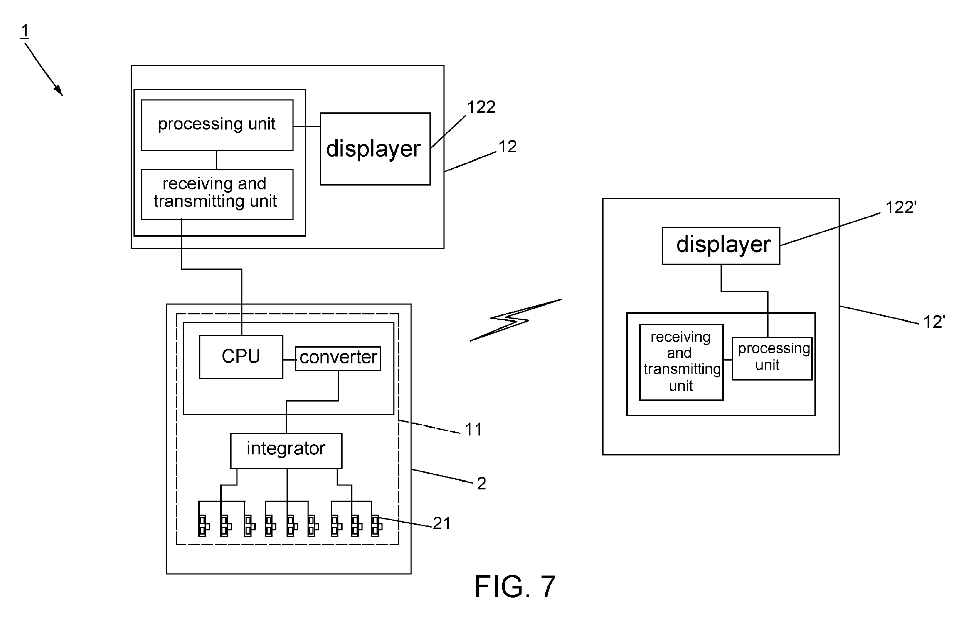

Referring to Fig. **7****,** a fourth preferred embodiment of the present invention shows a combination of the first to third preferred embodiments. Wherein, the connection between the detector **11** and the supervisor **12** is concurrently wired and wireless. That is to say, when the detector **11** installed on the transportation (not shown), the using condition of the battery **2** could be directly presented on the displayer **122** of the transportation via a wired way. Therefore, users could readily understand the voltage, temperature, and current information of the using battery cells **21.** As a result, if any battery cell **21** is founded unusual, a warning signal would be triggered and displayed on the displayer **122**. As to the wireless manual supervisor **12'** , it is suitable for the inspection and maintenance. In this manner, the displayer **122** showing the judging, comparison, and analysis of the data is not the only way to demonstrate; users could also directly achieve all the information on the displayer **122'** of the supervisor **12'** and decide whether to substitute the collapsed battery **2** or battery cells **21**. Obviously, the using convenience is greatly improved.

Referring to Fig**. 8**, a fifth preferred embodiment of the present invention shows that a battery pack A is formed by plural batteries **2** that are monitored by the battery monitoring system **1**. Wherein, the batteries **2** are serially or parallelly interconnected for the battery pack A to provide the sufficient electricity. Herein, the following description would take the fourth preferred embodiment as an example. When the number of the batteries **2** is increased, the detector **11** could also preferably detect if the battery cells **21** of each battery **2** are damaged and thence present the coherent information on the supervisor **12**. Therefore, users could swiftly get the information of the healthy condition of the batteries **2,** and the broken battery **2** or the battery cells **21** could be promptly inspected and picked out for a substitution.

Continuingly, the battery monitoring system **1** utilizes the sensors **113** to individually execute the omnibus inspection on the battery cell **21** of the battery **2**. Therefore, each sensor **113** installed on each battery cell **21** assists in a complete and precise detection, and users could be thoroughly aware of the variation inside the battery **2** while using. Accordingly, only the abnormal battery cell **21** would be promptly picked out for the subsequent maintenance and replacement, and it is needless to change the entire battery **2** or battery pack A in case only one of the battery cell **21** is damaged. Such means favorably decreases the cost and lessens the environmental pollution. Thus, the present invention achieves the object of efficiently monitoring the healthy status of the battery **2** and of increasing the convenience in installation as well as application.

To sum up, the present invention takes advantage of the sensors installed on each corresponding battery cell to achieve a comprehensive inspection upon the healthy status of each battery cell inside the battery, so that users would freely understand the physical condition of each battery. Therefore, the manipulation and subsequent replacement would be more speedy and convenient.

While we have shown and described the embodiment in accordance with the present invention, it should be clear to those skilled in the art that further embodiments may be made without departing from the scope of the present invention.

## Claims

1. A battery monitoring system (1) for monitoring a healthy status of a using battery (2); said battery (2) being formed by a plurality of battery cells (21) that are monitored by said monitoring system (1) ; wherein, said monitoring system (1) comprising a detector (11) and a supervisor (12) connected to said detector (11);
**characterized in that**, said detector (11) disposed in said battery (2) including an integrator (111), and a central processor (112) as well as a plurality of sensors (113) respectively connected to said integrator (111); wherein, said sensors (113) being correspondingly disposed on said of each battery cells (21) for respectively sensing a voltage signal and a temperature signal thereof; wherein, said integrator (111) integrating and transmitting said voltage and temperature signals to said central processor (112); said central processor (112) having a converter (1121) and a CPU (1122) connected to said converter (1121), so that said converter (1122) receiving said voltage and temperature signals transmitted from said integrator (111) for which to convert said signals into separate voltage and temperature data; said CPU (1122) previously saving a predetermined value for comparing with said voltage and temperature data; and said supervisor connected to said CPU (1122) for displaying a compared result from said CPU (1122) that compares said voltage data and said temperature data with said predetermined value, and said CPU (1122) friendly reacting to an irregular state of said compared result and emitting a warning signal to said supervisor (12) for which to promptly carry out a warning.

2. The monitoring system as claimed in claim 1, wherein, a sensor (113) is correspondently installed on each of said battery cell (21) for further detecting a current signal of said battery cell (21), and said current signal that is detected by said sensor (113) would be directly transmitted to said central processor (112) for being converted, compared and differentiated.

3. The monitoring system as claimed in claim 1, wherein, said supervisor (12) includes a controller (121) for receiving signals from said CPU (1122) and a displayer (122) connected to said controller (121).

4. The monitoring system as claimed in claim 3, wherein, said controller (121) has a receiving and transmitting unit (1211) for receiving signals from said CPU (1122) and a processing unit (1212) connected to said receiving and transmitting unit (1211).

5. The monitoring system as claimed in claim 3, wherein, said displayer (122) adopts a twinkling light for presenting an abnormal status.

6. The monitoring system as claimed in claim 1, wherein, a plurality of batteries (2) form a battery pack, and said batteries (2) are interconnected with each other.

7. The monitoring system as claimed in claim 2, wherein, a plurality of batteries (2) form a battery pack, and said batteries (2) are interconnected with each other.

8. The monitoring system as claimed in claim 3, wherein, a plurality of batteries (2) form a battery pack, and said batteries (2) are interconnected with each other.
